Europäisches Patentamt

European Patent Office

Office européen des brevets

(11) Publication number: 0 604 746 A2

# EUROPEAN PATENT APPLICATION

(21) Application number: 93118337.0

(22) Date of filing: 12.11.93

(51) Int. Cl.5: H03M 1/18

(30) Priority: 23.11.92 FI 925316

(43) Date of publication of application:
06.07.94 Bulletin 94/27

(84) Designated Contracting States:
DE FR GB IT NL

(71) Applicant: NOKIA TECHNOLOGY GmbH
Östliche Karl-Friedrich-Strasse 132
D-75175 Pforzheim(DE)

(72) Inventor: Mäkivirta, Aki, Dr.
Näyttelijänkatu 27 H 30
SF-33720 Tampere(FI)

(54) Circuit arrangement for expanding the virtual dynamic range of digital audio signal processor.

(57) A circuit arrangement is disclosed in which an analog audio signal is converted with an A/D converter provided with a given dynamic range into digital signal, the digital signal being taken into a digital audio signal processor DSP from which the processed signal thus obtained is converted with a D/A converter into an analog audio signal. The audio signal processor (24) DSP is provided with means for comparing the signal obtained from the A/D converter (23) with the dynamic range of the A/D converter and for arranging a digital control comparable to said difference. In front of the A/D converter (23) there is provided a first control means (22) in the signal path, changing, according to the digital control from the audio signal processor (24), the dynamic range of the audio signal to fully utilize the dynamic range of the converter. After the D/A converter (25) a second control means (26) is provided in the signal path, changing, according to the digital control from the audio signal processor (24), the dynamic range of the audio signal so that it is the same as the dynamic range of said audio signal prior to the first control means (22).

FIG. 2

Rank Xerox (UK) Business Services
(3.10/3.09/3.3.4)

The present invention relates to an arrangement in which an analog audio signal is converted with an A/D converter into digital before being applied to a digital signal processor (DSP), and in which the signal thus processed is thereafter converted back into an analog audio signal with a D/A converter. The arrangement is conventional in such audio applications in which an audio signal obtained from an audio source is processed by means of digital signal processing before being taken to a loudspeaker.

The dynamic range DR of the D/A converter is determined as a ratio of the highest output value and the noise level (not zero) indicated in decibels. The performance accuracy used by the converter (in fixed-point converters: the number of bits) indicates the number range covered in theory by the converter. It can be expressed by means of formula $DR = 20\log 2^n = 6.02 * n$, in which n is the number of the resolution bits. The formula shows that by addition of one bit the dynamic becomes improved by 6 dB on the condition that the system is assumed to be noiseless.

The theoretical dynamic range of the current analog / digital and digital/analog converters is from 42 to 96 dB (an 8-bit converter and a 16 bit converter), and this dynamics is also a limiting factor in any digital audio signal processing system. Therefore, e.g. the dynamic of a signal to be applied to an 8-bit converter must be below 42 dB, not to generate any overflow in the converter. The dynamic of the signal processor itself can be large, particularly if a floating-point processor is used. In a fixed-point processor, the dynamic is determined according to the above formula, but usually it is greater than the dynamic of the converter.

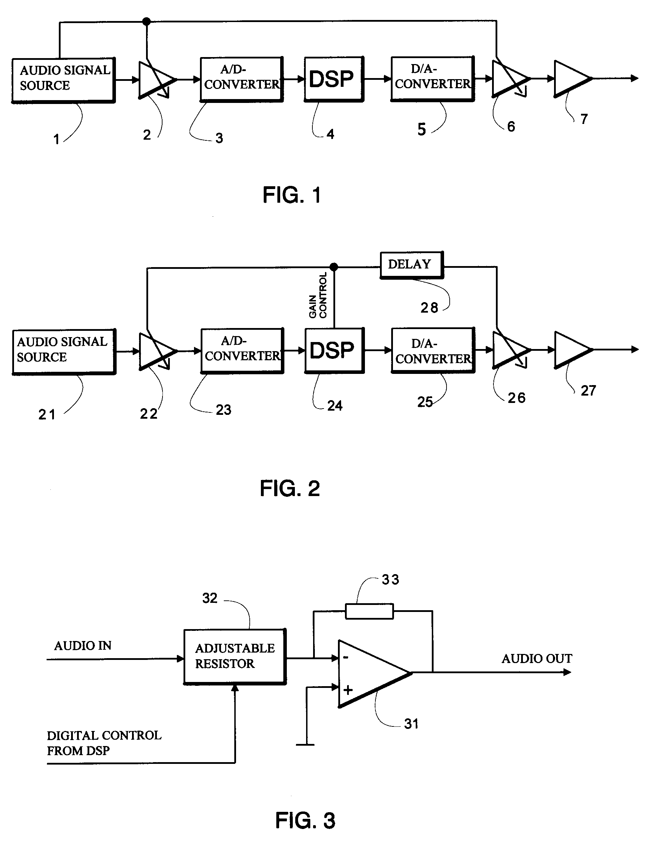

In practice, the limitation of the dynamic range causes problems if the level of the input audio signal can be higher than the dynamic range of the converter. A situation like this is manifest e.g. in vehicular radio use. A highly reduced application in current use is like the one shown in Fig. 1. The audio signal source is indicated by reference numeral 1, this being just anything, e.g. audio disk, cassette, etc. An analog audio signal is taken into a volume controller 2 where it is attenuated to an appropriate level. Thereafter the signal is taken to a digital audio signal processor 4 via an A/D converter 3 to be processed as desired. From the processor the signal is carried via a D/A converter 5 to an amplifier 6 to return the level prevailing before the attenuator 2. Finally, the signal is carried via a power amplifier 7 to a loudspeaker. The circuit arrangement described above could be e.g. the input circuit of an active loudspeaker, in which the converters, the amplifier / attenuator, the signal processor, and the power amplifier are located within the loudspeaker housing. It should be noted that the attenuation and the gain are controlled from the signal source and the signal is processed by the signal processor in the dynamic range which is the output of the A/D converter.

Let us assume in an instance like the one presented in Fig. 1 that the dynamic of the A/D and the D/A converters is 95 dB, this being the highest dynamic processable. Now, when wishing to attenuate a signal to be appropriate for the 40 dB normal listening level, the sound quality becomes impaired due to the effect of the two following factors:

1. The signal processor generates noise because the maximum dynamic range has diminished because of the attenuation, at the moment being 95 dB - 40 dB = 55 dB. Since the sound recorded on a CD disk rarely uses the two most significant bits out of the 16 bits available, the actual dynamic range of the useful signal input to the converter is, in the present example, when playing a CD record, approximately 55 dB - (2*6 dB) = 43 dB. If the audio signal is attenuated by more than 40 dB, the actual dynamic range becomes even smaller than what it was.

2. The small effective dynamic is associated with insufficient signal/noise ratio. This is bound to the first factor. When listening to a sound source at home and also in a car, the 43 dB dynamic range is too small. The noise caused by the conversions of the A/D converter 3 and the D/A converter 5 is added into the audio signal after controlling the sound volume carried out in the attenuator 2, whereby the basic noise of the converter / channel is audible on 43 dB level. Also the relative size of the quantization step increases because only part of the bits available in the converter are in use. For instance, a 16 bit bipolar converter yields theoretically $1/2^{15}$ for the quantization step. Since on the present example, only 8 bits out of 16 are effectively available, the quantization step will be $1/2^7$. The noise caused by a quantization step of that magnitude is practically speaking audible.

In principle, the above drawbacks can be eliminated by selecting a different type of converter or a converter with a greater number of bits. In practice, this will not, however, be of any help because in partly digital systems, such as the one example presented above, the basic noise will generate other limitations of its own. In the current state of art level, over 16 bit converters cannot moreover be used because of the technical requirements and high price level thereof.

The objective of the present invention is to provide a circuit arrangement involving none of the drawbacks of the above prior art circuit arrangement but with which the entire dynamic range of the converter can be utilized completely, and thus enhance the overall performance level of the system.

The above aim can be achieved according to claim 1 so that a signal entering an A/D converter and the output signal output from D/A converter are controlled with control means controlled by DSP in that with a level control before the A/D converter a signal entering the converter is amplified by utilizing the entire dynamic range, and by utilizing another level control means provided after the D/A converter, the output signal is controlled to be on a level prevailing prior to the first control means. Thus, the overall gain of the system is 1.0, and at the same time the effective dynamic of the signal, being usually a lot less than the maximum dynamic, has been optimally adapted with the effective dynamic of the converter.

In the present invention, the idea has been utilized that the output of the signal is accomplished by the digital audio signal processor. The processor judges from the signal output from the A/D converter whether the entire dynamic range has been used or not, thus controlling the level control means accordingly. For the level control means, a resistively backfed operational amplifier can be used, the gain thereof being controllable with a resistor network controlled by DSP. The control circuit of a second level control means comprises a delay means in which the delay is equivalent to the time passed by the signal travelling from an A/D converter to a D/A converter, whereby the gain in the input and the attenuation in the output are carried out on the same signal part.

The invention is described below with the aid of the accompanying exemplary schematic figures, in which

Fig. 1 presents a state of art arrangement,
Fig. 2 presents the principle of the arrangement according to the invention,
Fig. 3 shows an attenuator/amplifier circuit arrangement,
Fig. 4 presents an opportunity for a controlled resistor.

The arrangement of Fig. 1 is described above. The arrangement according to Fig. 2 greatly resembles the arrangement of Fig. 1. A signal obtained from an audio signal source 21, e.g. from a CD-player, is taken to a controllable amplifier 22. Therein, according to the control obtained from a signal processor, the gain is increased or decreased so that the level of the signal carried to the A/D converter 23 approaches the maximum input voltage of the converter, the amplitude thereof not, however, being there-above. Hereby, the dynamic range of the analog - digital conversion is available maximally. A digital signal thus converted by the converter is next carried to a digital signal processor processing the signal as desired. The signal thus processed by the processor 24 is carried therefrom to a D/A converter 25 converting the signal into an analog signal. Also said converter has now a maximum dynamic range available. Next, the signal is carried to a second controllable amplifier 26, amplifying or attenuating the signal controlled by the DSP 24 so that the power thereof is after the amplifier the same as prior to the amplifier 22. Finally, the signal thus obtained can be amplified in a power amplifier 27 before being taken into a loudspeaker.

The signal processor 24 controls the gain/attenuation of both controllable amplifiers through the "gain control" of the control line. The control data can be the same for both amplifiers even if the data carried to the second amplifier 26 only is interpreted in the amplifier as the negation thereof, i.e. if the "gain control" is e.g. -10 dB, it means that the amplifier 22 amplifies the audio signal by said amount and respectively, the second amplifier 26 amplifies by the same amount. Since the travelling of the signal between the amplifiers 22 and 26 requires a given length of time, a delay member 28 must be added into the branch entering the amplifier 26 to delay the control signal by equal length of time. Hereby, the gain or attenuation of the amplifier 26 is aimed at the same signal period as the corresponding operations of the amplifier 22. The delay is a constant for the delay caused by the signal processor and the converter is constant. The delay is supposed to be a multiple in magnitude of the sampling period.

The requirements which the control of the amplifiers has to meet are great. When the level of a signal entering any digital signal processing system (or any linear system) changes abruptly, it causes a rise in the response of the system. This feature can be so modelled that a step signal is superponed in the original signal. Since said step resonance can be clearly audible, a change in the step in the signal amplitude has to be made as small as possible in order to minimize the disturbance thereof. If the conventional dynamic of the useful signal can be inserted into the dynamic range of the converter used, no changes need be made, instead, the input level once optimized correctly can be maintained constant, and there is no drawback caused by any step changes.

If even this process cannot be achieved, the gain control must be provided with a great variety of potential gain / attenuation values, so that the listener will not hear a change in the gain. Therefore, a resistor network composed of several resistors is appropriate for the overall resistance thereof can be so controlled that with a small resistor network a great number of resistor values are provided, whereby the magnitude of subsequent resistor values can be made smaller.

According to a preferred embodiment, the attenuator / amplifier connection is used as the one shown in Fig. 3. It comprises an operational amplifier 31 fedback with a resistor 33, to the inverting terminal whereof being carried an input signal Vin via a controllabe resistor 32. As in the state of art, the output voltage Vout is determined by the ratio of resistors 33 and 32. The circuit arrangement may be any known in the art, on the condition that the output voltage is determined from the resistor ratio as described above. The resistor 32 is a ladder network constructed of resistors of the same size. The network is preferably of the same type as used within the A/D and A/D converter circuits currently used.

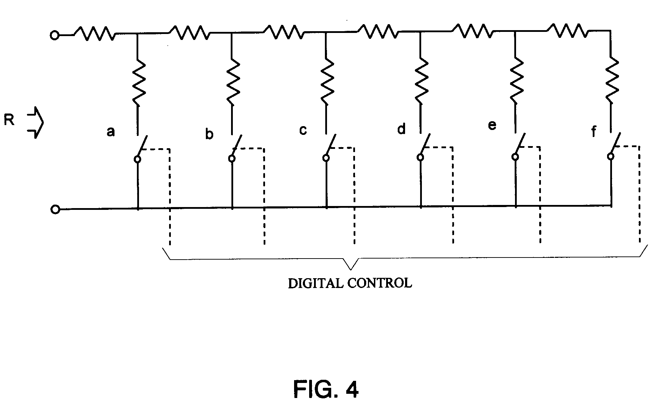

A proposition for a resistor network is shown in Fig. 4. More resistors can be connected to the ladder, or removed therefrom, with the aid of electronic switches a-f, whereby the overall resistance of the network and thus, the value of the resistor 32 can be changed in small steps, so that the output voltage $V_{out}$ of the network can be maintained almost constant, with the respectively changing input voltage $V_{in}$. The switches a-f are controlled by a digital control signal derived from the signal processor 24. The bit number of the control signals can be selected freely and the more there are bits, the greater setting accuracy of the resistor 32 can be achieved. As regards the production, the network is advantageous because no accurate absolute resistor values are needed, instead, the relative values only have to be exact.

The signal processor must adjust the attenuation / gain of the amplifier 22 and 26. For that purpose, it must be able to predict the incoming audio signal. Hereby, the gain, respectively attenuation, can be controlled by optimizing the dynamic range of the converters, minimizing the noise produced by DSP, and maximizing the signal / noise level ratio. The gain / attenuation is controlled stepwise by a resistor of the network at a time, so that the change would not be audible.

If the amplitude value of the input signal exceeds the dynamic range of the converter that moment, the clipping of the signal causes distortion. If the attenuation / gain parameters have been advantageously controlled, the distortion will be limited to a first transient and the amount of disturbance is minimized. In practice, it is often also possible to find the gain value at which no clipping occurs at all. Also predictive methods can be used in optimizing the dynamic so that the amount of distortion is minimized.

Let us assume that a signal entering into the system of Fig. 2 has been attenuated in the attenuator 22 by 30 dB. When in the amplifier 26 it is amplified with an equal amount, the signal cannot exceed the voltage range of the A/D converter 23. When the average amplitude of the signal becomes smaller, the amplifiers 23 and 25 are become adapted to said change. When the attenuation / gain is changed, the amount of the noise of the input signal (i.e. the noise included in a record) will not change, but the noise caused by the DSP and the converters has reduced to a minimum.

The signal / noise ratio of the attenuator / amplifier 23, 26 itself may in certain instances be a discriminating factor. It is required to be of sufficient magnitude in order to cover both the required control range and the dynamic range of the DSP. According to an earlier example we may assume that the gain control is 40 dB and the dynamic range of the DSP is 95 dB. The dynamic of the attenuator / amplifier 23, 26 has to be 95 dB + 40 dB = 135 dB in order not to be the factor discriminating the dynamic of the system. This is technically achievable.

The design of the invention includes a number of advantages. It is easy to apply in the current systems processing the audio signal implemented with the DSP. Only a few program additions need to be made in the processor. The appropriate manufacturing technology of the controllable resistor is known already in current A/D and D/A converters in which an integrated resistor network is used. The setting precision of the resistor can be improved by adding the bit number of the control from the DSP, though increasing the size of the ladder network to some extent. It is important that with the aid of the invention less expensive converters with a smaller number of bits can be used while the end result sounds however, the same as if it had been produced using a converter with greater number of bits.

The practical design of the invention can be implemented in different ways while maintaining within the protective scope of the invention. An essential feature is, however, that the attenuator / amplifier is controlled by the signal processor itself and in the attenuator/amplifier a digitally controllable resistor, such as ladder network, can be used.

The system introduced here has been experimented with an eight-bit converter, and it has been found that when using a converter like this conventionally, the distinctly audible quantization noise when in use has disappeared to the extent that when listening to a CD record, the end result thereof sounds the same as an original 16 bit CD recording produced when using a 16 bit converter.

## Claims

1. A circuit arrangement in which an analog audio signal is converted with an A/D converter provided with a given dynamic range into digital, said digital signal being taken into a digital audio signal processor DSP, the processed signal thus provided is converted into an analog audio signal converted with a D/A converter, **characterized** in that

- the audio signal processor (24) DSP is provided with means for comparing a signal from the A/D converter (23) with the dynamic range of the A/D converter, and for providing a digital control comparable to said difference,
- in the signal path in front of the A/D converter (23) there is provided a first control means (22) changing, according to the digital control from the audio signal processor (24), the dynamic range of the audio signal so that it is approximately the same as the dynamic range of the A/D converter (23), and
- in the signal path after the D/A converter (25) there is provided a second control means (26) changing, according to the digital control from the audio signal processor (24), the dynamic range of the audio signal so to be the same as the dynamic range of said audio signal prior to the first control means (22).

2. Circuit arrangment according to claim 1, **characterized** in that the second control means (26) changes the dynamic range of the audio signal by an equal amount but in reverse direction to that of the first control means (22), and that the control of the second control means is taken, relative to the control of the first means, delayed by a length of time corresponding to the travelling time of the audio signal from the input of the A/D converter (22) to the output of the D/A converter (25).

3. Circuit arrangement according to claim 1, **characterized** in that a controllable resistance (32) is included in the first and second control means, a change in the resistance whereof being step-wise, and the output voltage of both control means (22,26) changing in proportion to a change of the controllable resistance.

4. Circuit arrangement according to claim 3, **characterized** in that the controllable resistance is composed of a ladder network in which all resistances are of equal size and in which the number of the resistances included in the network is selected by digital control.

5. Circuit arrangement according to claim 4, **characterized** in that the digital control is parallel in shape and each control bit is affected by a grid of a semiconductor switch, said switch switching the resistances connected thereto to the network or off therefrom.

6. Circuit arrangement according to claim 3, **characterized** in that the first and second control means are composed of a resistively backfed operational amplifier (31) in which the input signal is carried to the amplifier through controllable resistance (32).

7. Circuit arrangement according to claim 2, **characterized** in that a predicting algorithm is used for controlling the dynamic.

8. Circuit arrangement according to claim 2, **characterized** in that for controlling the dynamics a method is used in which on the basis of the past information, endeavours are made to minimize the disturbance caused by the control of the gain.

**FIG. 1**

AUDIO SIGNAL SOURCE — 1

2

A/D-CONVERTER — 3

DSP — 4

D/A-CONVERTER — 5

6

7

**FIG. 2**

DELAY — 28

GAIN CONTROL

AUDIO SIGNAL SOURCE — 21

22

A/D-CONVERTER — 23

DSP — 24

D/A-CONVERTER — 25

26

27

**FIG. 3**

32

33

AUDIO IN

ADJUSTABLE RESISTOR

−

+

AUDIO OUT

31

DIGITAL CONTROL FROM DSP

FIG. 4